Europäisches Patentamt

European Patent Office

Office européen des brevets

(11) Numéro de publication : **0 433 141 B1**

# (12) FASCICULE DE BREVET EUROPEEN

(45) Date de publication du fascicule du brevet :
**01.07.92 Bulletin 92/27**

(51) Int. Cl.⁵ : **G06F 11/20**

(21) Numéro de dépôt : **90403478.2**

(22) Date de dépôt : **06.12.90**

(54) **Circuit de redondance pour mémoire.**

(30) Priorité : **11.12.89 FR 8916338**

(43) Date de publication de la demande :
**19.06.91 Bulletin 91/25**

(45) Mention de la délivrance du brevet :
**01.07.92 Bulletin 92/27**

(84) Etats contractants désignés :
**DE FR GB IT**

(56) Documents cités :
**EP-A- 0 104 120**
**FR-A- 2 611 301**
**US-A- 4 601 019**
**IEEE JOURNAL OF SOLID-STATE CIRCUITS,**
**vol. 24, no. 1, février 1989, pages 43-49, IEEE,**
**New York, US; Y. NISHIMURA et al.:**
**"Aredundancy test-time reduction technique**
**in 1-Mbit DRAM with a multibit test mode"**

(73) Titulaire : **SGS-THOMSON**
**MICROELECTRONICS S.A.**
**7, Avenue Galliéni**
**F-94250 Gentilly (FR)**

(72) Inventeur : **Conan, Bertrand, Cabinet**
**Ballot-Schmit**
**7, rue Le Sueur**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

**Description**

L'invention concerne les mémoires réalisées en circuit-intégré et, plus particulièrement, dans une mémoire qui comporte des colonnes redondantes, un circuit d'activation de colonnes redondantes.

Plus les mémoires ont une grande capacité de stockage et plus la technologie d'intégration est fine, plus ces mémoires sont sujettes à des défauts de fabrication. En effet, il est très difficile d'avoir à la fois une très petite taille de circuit-intégré, une très grande capacité de stockage dans cette petite taille et un bon rendement de fabrication. Un seul défaut dans une mémoire comportant un million de cellules peut entraîner la mise au rebut de la mémoire.

Pour augmenter le rendement de fabrication, on utilise des mémoires comportant des systèmes de redondance, c'est-à-dire comportant plus de cellules de mémoire qu'il n'est nécessaire et des circuits de connexion pour pouvoir utiliser les cellules supplémentaires ("cellules redondantes") à la place de cellules normales qui s'avèrent défectueuses. Lors du test de la mémoire, on détecte les cellules défectueuses, on établit électriquement des chemins de connexion permettant de déconnecter les cellules défectueuses et de connecter à la place des cellules redondantes, de sorte que la mémoire apparait globalement bonne à l'utilisateur malgré la présence d'éléments défectueux.

Les mémoires sont organisées en principe en rangées et en colonnes de cellules; on lit sur un conducteur de colonne (parfois appelé "ligne de bit") l'information contenue dans une cellule située au carrefour de cette colonne et d'une rangée déterminée définie par une adresse de rangée.

Les systèmes de redondance couramment utilisés ne remplacent pas en général une cellule défectueuse par une cellule redondante. Ils remplacent plus souvent une rangée ou une colonne comportant un ou plusieurs défauts par une rangée ou une colonne redondante.

Pour les mémoires de grande capacité destinées à fournir des données sous forme de mots de z bits, on prévoit que le nombre de colonnes est bien supérieur à z. Par exemple on a 512 colonnes même si on veut fournir des mots de 8 ou 16 ou 32 bits à la sortie de la mémoire. Dans ce cas, les colonnes sont agencées en z ensembles de colonnes, chaque ensemble correspondant à un plot de sortie de donnée de la mémoire; sur chaque plot on recueille à chaque lecture une donnée issue d'une colonne déterminée d'un ensemble correspondant à ce plot et pas à un autre. Il y a z plots et z ensembles : un plot par ensemble.

On notera en passant que dans tout ce qui suit on considérera seulement l'aspect lecture de données contenues dans la mémoire; mais bien entendu, si la mémoire est une mémoire inscriptible électriquement (mémoire RAM ou EPROM ou EEPROM, etc.) les plots servent en même temps à introduire des données dans les cellules de mémoire pour l'écriture. Comme cela ne change rien au problème de la redondance, on ne parlera dans la suite que de lecture pour ne pas alourdir la description de l'invention. Si on doit prendre en compte également l'écriture, il suffit de rajouter les éléments nécessaires à l'écriture, et en particulier des amplificateurs d'écriture connectés entre les plots et les ensembles de colonnes.

Dans les réalisations les plus simples, à chaque plot correspond un amplificateur de lecture de données mémorisées.

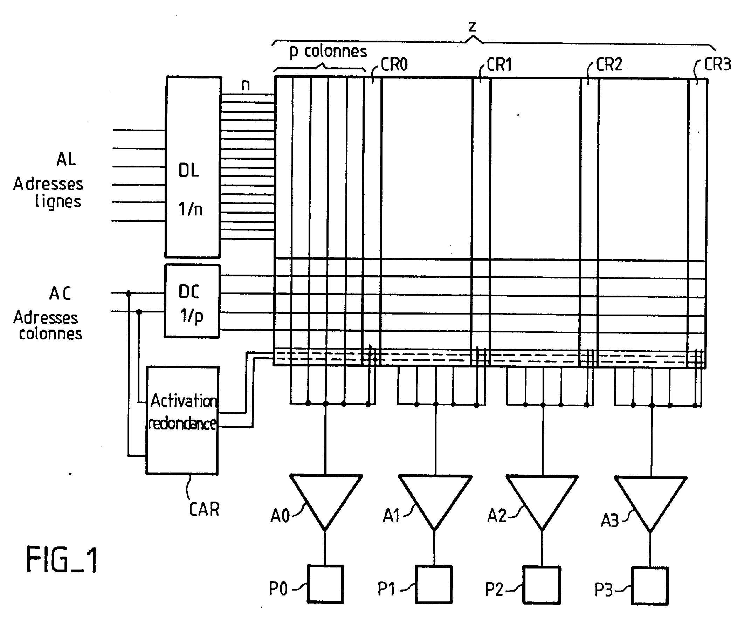

La figure 1 représente très schématiquement une mémoire de ce type : la mémoire est organisée en mots de z bits; il y a z plots de sortie (P0 à P3), z amplificateurs de lecture (A0 à A3), z ensembles de colonnes correspondant chacun à un amplificateur et un plot respectif. Chaque ensemble comporte p colonnes de cellules. Enfin, chaque colonne comporte n cellules, c'est-à-dire que la mémoire comporte n rangées de cellules.

Il y a un décodeur de ligne DL destiné à recevoir une adresse de ligne AL et à sélectionner une rangée parmi n en fonction de cette adresse. Il y a un décodeur de colonne destiné à recevoir une adresse de colonne AC et à sélectionner une colonne parmi p en fonction de cette adresse. La sélection d'une adresse de colonne ne désigne pas une seule colonne mais une colonne dans chacun des z ensembles et connecte cette colonne à l'amplificateur de lecture et donc au plot de sortie correspondant. L'application d'une adresse de ligne et d'une adresse de colonne établit donc sur les sorties un mot de z bits issu de z colonnes. ces z colonnes sont réparties dans les z ensembles; elles occupent toutes le même rang (parmi p rangs possibles) dans les différents ensembles. L'adresse de colonne désigne en fait un rang déterminé parmi p, pour tous les ensembles simultanément.

La mémoire peut comporter des rangées redondantes (non représentées car on ne s'intéresse dans cette invention qu'à la redondance de colonnes) et des colonnes redondantes; on prévoit par exemple un groupe de colonnes redondantes pour chacun des z ensembles. Les groupes de colonnes redondantes, globalement désignés par les références CR0 à CR3, sont commandés par un circuit d'activation de redondance CAR. Ce circuit reçoit les adresses de colonnes AC, vérifie si elles correspondent à une adresse de colonne défectueuse, et, dans l'affirmative, désactive le décodeur de colonne DC et sélectionne une colonne de redondance en remplacement.

Compte tenu du peu de place dont on dispose dans la mémoire, on s'arrange en pratique pour que le circuit de sélection désigne une colonne de redondance simultanément dans chacun des groupes CR0 à CR3 (de même que le décodeur de colonne DC sélectionne simultanément une colonne de chaque ensemble). Mais cela veut dire que lorsqu'une colonne est défectueuse, dans un ensemble déterminé, on remplace non seulement cette colonne mais toutes les colonnes ayant la même adresse de colonne et faisant partie des autres ensembles. On pourrait prévoir une autre organisation de redondance, dans laquelle on ne remplace que la colonne défectueuse, mais cela supposerait des circuits logiques supplémentaires d'aiguillage assez complexes, qu'on n'a en général pas la place de mettre dans le circuit intégré car ils encombrent fortement la périphérie immédiate du réseau de cellules mémoire.

L'organisation de la redondance est similaire mais se complique dans des mémoires organisées différemment, et en particulier des mémoires qui, en raison de leur forte capacité de stockage et de leur densité d'intégration, comportent plusieurs amplificateurs de lecture (2 ou 4 ou même plus) par plot de donnée. Un bit d'adresse (ou 2 ou plus) est réservé à la sélection de l'amplificateur de lecture. L'ensemble de colonnes associé à chaque plot est alors maintenant divisé en plusieurs groupes correspondant chacun à un amplificateur de lecture respectif.

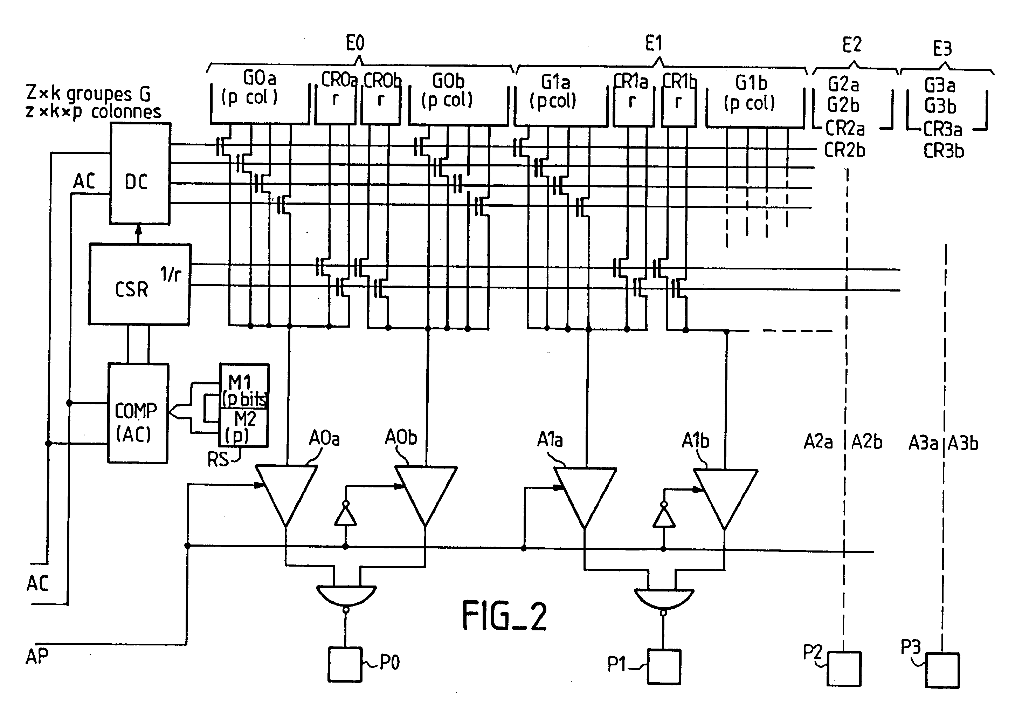

Une telle mémoire est représentée à la figure 2. L'organisation des rangées et le décodeur de ligne ne sont pas représentés, puisque seul l'agencement des colonnes intéresse la redondance de colonnes.

Il y a z ensembles de colonnes, désignés par E0 à E3 et correspondant chacun à un plot respectif P0 à P3. Chaque ensemble comporte K groupes (ici k=2) et chaque groupe correspond à un amplificateur respectif connecté au plot qui est associé à l'ensemble. Les groupes sont désignés par G0a et G0b pour le premier ensemble E0, et par G1a et G1b pour le deuxième ensemble E1, etc. Les amplificateurs sont désignés par A0a et A0b pour le premier ensemble E0, et par A1a et A1b pour le deuxième, etc.

Chaque groupe comporte p colonnes. L'application d'un mot sur les z sorties de la mémoire se fait par sélection d'une adresse de ligne AL, d'une adresse de colonne AC, et d'une adresse de post-sélection AP. L'adresse de ligne AL désigne une rangée de cellules; l'adresse de colonne AC désigne une colonne parmi p dans chaque groupe, c'est-à-dire au total k fois z colonnes, toutes les colonnes ayant le même rang parmi p rangs dans leur ensemble respectif; enfin, l'adresse de post sélection AP définit un rang d'amplificateur parmi k dans chaque ensemble, ou, ce qui revient au même, un rang de groupe de colonnes parmi k rangs de groupe dans un ensemble; cela a pour conséquence la sélection d'un amplificateur parmi k dans chaque ensemble, c'est-à-dire z amplificateurs au total ayant tous le même rang parmi k rangs. Sera transmis aux plots de données un mot de z bits issu de colonnes ayant toutes le même rang (défini par AC) dans les groupes auxquels elles appartiennent, les groupes ayant eux-mêmes tous le même rang (défini par AP) dans les ensembles auxquels ils appartiennent.

On voit sur la figure 2 comment on effectue la sélection de colonnes et la post-sélection à partir de l'adresse d'un mot qui comprend (outre l'adresse de ligne AL) les deux parties d'adresse AC et AP.

Associé à chaque groupe de colonnes G0a, G0b à G3a, G3b, on a prévu un groupe de colonnes de redondance respectif CR0a, CR0b à CR3a, CR3b.

Chaque groupe de colonnes de redondance comprend r colonnes, ce qui signifie qu'avec un groupe on peut réparer a priori r colonnes défectueuses. Toutefois, l'architecture ne permet pas, comme on va le voir de réparer un nombre total de colonnes de z fois k fois r (z.k.r), bien qu'il y ait 2 fois k fois r colonnes de redondance. En effet, pour les mêmes raisons que celles indiquées en référence à la figure 1, le circuit de sélection de colonnes de redondance va sélectionner une colonne parmi r simultanément dans tous les groupes, de sorte qu'on réparera r défauts au plus. Dans l'exemple représenté, r=2 : il y a deux colonnes de redondance dans chacun des deux groupes de chacun des quatre ensembles.

La figure 2 indique la constitution globale du circuit de sélection de colonnes de redondance : il comporte un comparateur (COMP) recevant l'adresse de colonne AC et comparant cette adresse avec des adresses mémorisées dans un registre de stockage d'adresses de colonnes défectueuses (RS). S'il y a coïncidence, le comparateur désactive le décodeur de colonne DC pour l'empêcher de sélectionner la colonne défectueuse et active un circuit de sélection de colonne redondante CSR. Ce dernier sélectionne, en fonction du résultat de la comparaison, une des r colonnes de redondance de chaque ensemble, simultanément pour tous les ensembles. Sont donc sélectionnées toutes les colonnes de redondance de même rang (parmi r rangs possibles) des divers groupes CR0a, CR0b à CR3a, CR3b.

Le registre de stockage d'adresses RS comporte au maximum r mémoires, permettant chacune de stocker l'adresse d'une colonne parmi p. L'adresse effectivement stockée est l'adresse de colonne AC d'une colonne défectueuse, indépendamment du groupe auquel elle appartient. Toutes les colonnes ayant même adresse de colonne AC sont remplacées par des colonnes de redondance ayant même rang parmi r. Il y a z.k remplacements pour une colonne défectueuse.

Pour augmenter les possibilités de remplacement de colonnes défectueuses, ce qui est souhaitable lorsque la taille de la mémoire augmente, il y a plusieurs solutions :

– la première est évidemment d'augmenter r; mais cela augmente beaucoup la taille de la mémoire puisqu'il y a r fois k fois z colonnes redondantes; de plus, cela présente un risque car les colonnes redondantes elles-mêmes peuvent être défectueuses.

– la deuxième est de faire en sorte que le circuit de sélection de redondance soit capable de sélectionner indifféremment n'importe quelle colonne de redondance et de l'aiguiller vers n'importe quel amplificateur, sans sélectionner obligatoirement simultanément une colonne dans tous les groupes. Mais cette solution utilise beaucoup de circuits d'aiguillage, justement à des endroits proches des sorties de colonne où l'on n'a pas beaucoup de place.

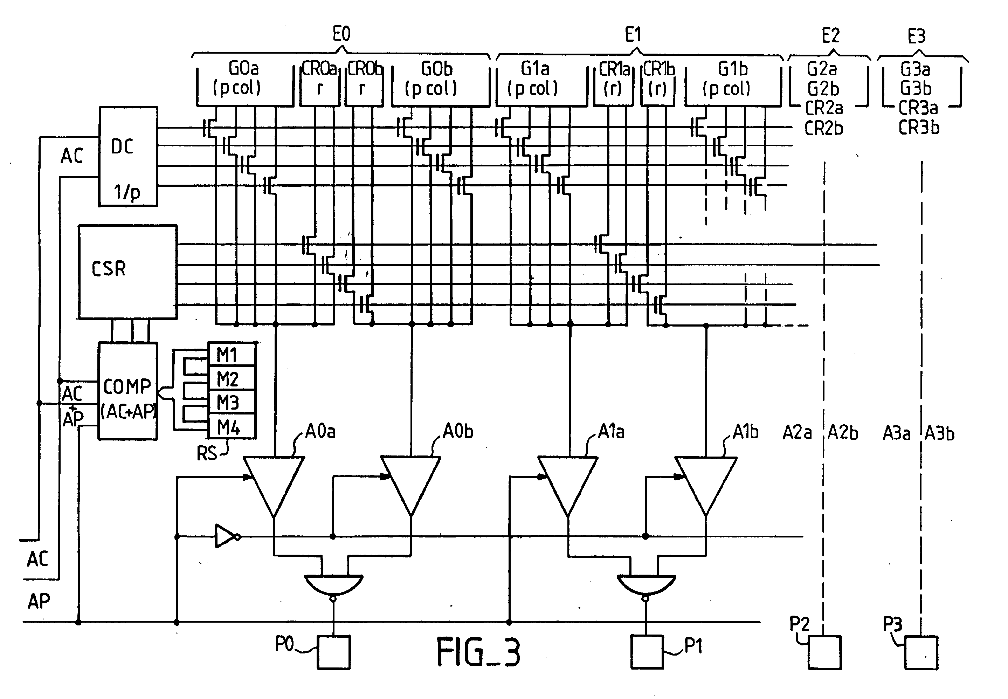

– une troisième solution possible est représentée à la figure 3. Elle consiste à utiliser un circuit de sélection CSR qui commande séparément les colonnes de redondance des k différents groupes. Le circuit de sélection va désigner une colonne parmi k.r dans chaque ensemble et non une colonne parmi r dans chaque groupe; seules seront sélectionnées les colonnes de redondance qui sont dans des groupes de même rang; pour illustrer cela, on peut dire par exemple qu'on sélectionne la deuxième colonne redondante des groupes de colonnes redondantes CR0a, CR1a, CR2a, CR3a, mais sans sélectionner pour autant la deuxième colonne redondante des autres groupes CR0b à CR3b. A la figure 2, on sélectionnait nécessairement toutes les deuxièmes colonnes de tous les groupes CR0a, CR0b à CR3a, CR3b. On multiplie donc en gros par k les possibilités de redondance, sans augmenter le nombre total de colonnes redondantes. Mais là encore, la réalisation est difficile par suite du peu de place dont on dispose à proximité immédiate du réseau de cellules et des décodeurs. Le comparateur, le circuit de sélection CSR sont plus compliqués, et il faut au moins k fois r lignes de sortie pour le circuit CSR au lieu de r lignes seulement.

La présente invention a pour but de proposer un circuit d'activation de redondance qui permette une augmentation des possibilités de réparation d'une mémoire du type de la figure 2 ayant plusieurs amplificateurs par plot de donnée. L'amélioration est du même ordre que celle obtenue à la figure 3 par rapport à la figure 2, mais elle minimise les problèmes d'encombrement en rejetant vers des zones périphériques peu encombrées les connexions rajoutées en vue de l'augmentation des possibilités de réparation.

Selon l'invention, on propose essentiellement d'utiliser un registre de stockage des adresses défectueuses qui comporte k groupes de r zones de mémoire permettant de contenir chacune une adresse de colonne. Chaque groupe de zones correspond à un rang d'amplificateur parmi k. Chaque groupe de r zones de mémoire sera dédié à la réparation des colonnes du groupe correspondant à un amplificateur de rang donné et ne pourra pas réparer les colonnes correspondant aux autres amplificateurs et aux autres groupes de colonne n'ayant pas le même rang. L'adresse de post sélection AP servant à désigner le rang des amplificateurs à utiliser et servant effectivement à activer tous les amplificateurs de ce rang, servira aussi à désigner le groupe de mémoires d'adresses défectueuses et à activer uniquement le groupe du rang correspondant à celui des amplificateurs activés.

Par conséquent, le circuit de sélection CSR reste le même qu'à la figure 2 et agit de la même manière sur les colonnes redondantes, mais le comparateur est susceptible d'être connecté à k fois r zones de mémoire (et non pas r zones comme à la figure 2), et l'adresse de post sélection reçue par la mémoire désigne un groupe parmi les k groupes de zones de mémoire pour que ce groupe soit effectivement connecté au comparateur.

Les possibilités de réparation sont aussi élevées qu'avec le circuit de la figure 3 : on peut réparer indépendamment r colonnes défectueuses situées dans des groupes de même rang parmi k, et cela pour chacun des rangs.

Par comparaison, on notera qu'à la figure 3 le comparateur est connecté en permanence à k fois r zones de mémoire et doit fournir au circuit de sélection non seulement un rang parmi r mais aussi un rang parmi k. De plus, les zones mémoires dans le cas de la figure 3 doivent stocker à la fois l'adresse de colonne AC et l'adresse de post sélection AP, et le comparateur doit fournir une comparaison sur ces deux portions d'adresse. Dans l'invention, le comparateur n'est connecté à un moment donné qu'à r zones et non k fois r, il désigne un rang parmi r, et enfin il fait des comparaisons seulement sur les adresses de colonne AC. Par ailleurs, le circuit selon l'invention permet de rejeter à la périphérie de la mémoire (là où sont les registres de stockage d'adresses défectueuses) les connexions supplémentaires nécessitées par l'accroissement des possibilités de réparation. Il ne nécessite pas de placer des aiguillages là où on n'aurait pas de place, c'est-à-dire entre les sorties des colonnes et les amplificateurs.

Une définition structurelle détaillée de la mémoire selon l'invention pourrait être la suivante :

Un circuit d'activation d'une colonne de redondance dans une mémoire intégrée avec redondance de colonnes de données, la mémoire comportant :

– un réseau d'éléments de mémoire organisés en n rangées et z ensembles de k groupes de p colonnes, avec n, z, k et p différents de l'unité, chaque ensemble correspondant à un plot de données respectif parmi z, et chaque groupe correspondant à un amplificateur de lecture respectif parmi k amplificateurs connectés à ce plot, de telle manière qu'une donnée d'une colonne d'un groupe déterminé dans un ensemble déterminé soit appliquée au plot correspondant à cet ensemble par l'amplificateur correspondant à ce groupe,

– un décodeur de colonne pour sélectionner une colonne parmi p simultanément dans tous les groupes de tous les ensembles, et un moyen de post-sélection pour sélectionner un amplificateur parmi k simultanément dans tous les ensembles, en fonction de la réception par la mémoire d'une adresse de colonne parmi p adresses, et d'une adresse de groupe parmi k, cette adresse de groupe définissant un rang de groupe dans chaque ensemble, le circuit d'activation de colonne redondante étant caractérisé en ce qu'il comprend

– r colonnes de redondance par groupe dans chacun des ensembles, pour remplacer au moins une colonne défectueuse dans le réseau, r supérieur ou égal à l'unité, les r colonnes de redondance d'un groupe étant reliées directement à l'amplificateur correspondant à ce groupe,

– un circuit de sélection de colonne de redondance pour sélectionner une colonne de redondance parmi r simultanément dans tous les groupes de tous les ensembles, c'est-à-dire pour sélectionner simultanément z.k colonnes de redondance de même rang (1 parmi r) appartenant toutes à des groupes et des ensembles différents,

– k groupes de mémoires de stockage d'adresses de colonnes défectueuses, chaque groupe de mémoires comportant en mémoire r adresses de colonne et chaque adresse permettant de désigner une colonne parmi p, chaque groupe de mémoires étant dédié au stockage d'adresses de colonnes défectueuses correspondant à un seul rang de groupe de colonnes parmi k, sans distinction entre les ensembles auxquels peuvent appartenir les colonnes défectueuses (c'est-à-dire que le premier groupe de mémoires correspond à une adresse de colonne défectueuse qui appartient au premier groupe de n'importe lequel des ensembles, le deuxième groupe de mémoires correspond à une adresse de colonne appartenant au deuxième groupe de colonnes de n'importe quel ensemble, etc.),

– un moyen de sélection de groupe de mémoires, apte à sélectionner un groupe de mémoires parmi k lors de la réception par la mémoire d'une adresse de groupe parmi k,

– un moyen pour comparer une adresse de colonne parmi p, reçue par la mémoire, à toutes les adresses d'un groupe de mémoires sélectionné, et pour d'une part inhiber le décodeur de colonnes (mais non le moyen de post sélection) et d'autre part commander la sélection par le circuit de sélection de colonne de redondance d'une colonne de redondance déterminée en fonction du résultat de la comparaison.

D'autres caractéristiques et avantages de l'invention apparaîtront à la lecture de la description détaillée qui suit et qui est faite en référence aux dessins annexés dans lesquels :

    – les figures 1 à 3 déjà décrites, représentent des structures de mémoires et de systèmes de redondance présentant des imperfections;

    – la figure 4 représente un schéma de principe d'un système de redondance selon l'invention.

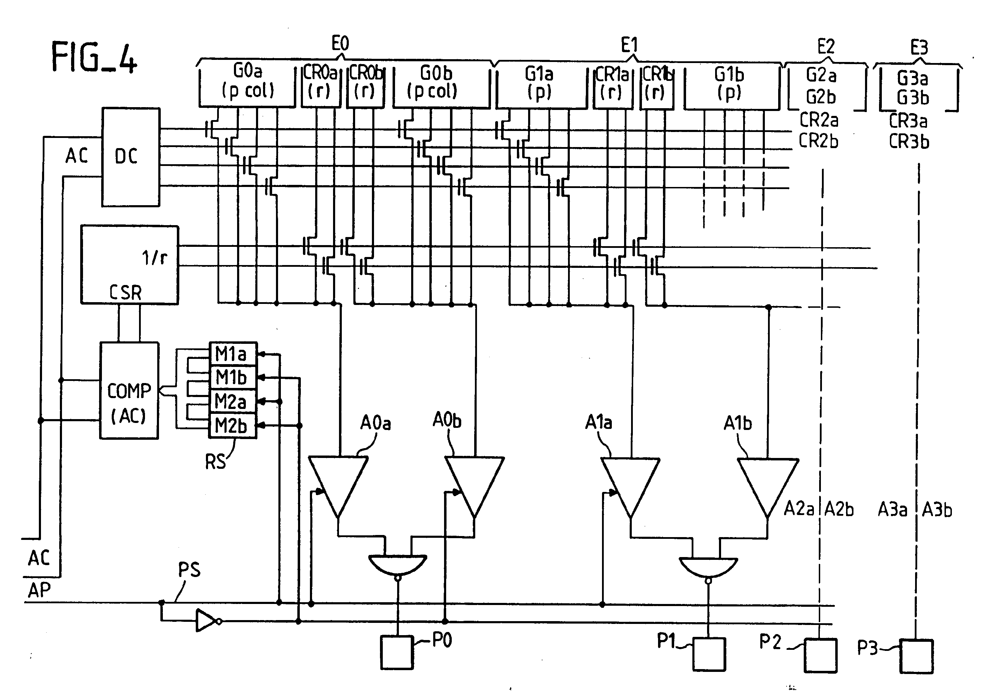

On ne reviendra pas en détail sur l'arrangement matriciel général de la figure 4 : c'est le même que celui qui a été décrit en référence aux figures 2 et 3.

Il y a z ensembles de k groupes de p colonnes de cellules de mémoire d'un réseau principal, et z ensembles de k groupes de r colonnes de redondance, chaque groupe de colonnes de redondance correspondant à un groupe de colonnes de cellules de mémoire du réseau principal. En outre, chaque groupe correspond à un amplificateur, et les différents amplificateurs correspondant à un même ensemble sont connectés à un même plot de sortie de donnée. Il y a donc z plots de sortie ( P0 à P3 sur la figure). Les amplificateurs du premier ensemble sont A0a et A0b correspondant aux groupes G0a et G0b respectivement, A1a et A1b correspondant aux groupes G1a et G1b, etc.

Le rang de la colonne parmi p rangs possibles à l'intérieur d'un groupe est défini par une adresse de colonne AC. Le rang du groupe ou de l'amplificateur parmi k rangs possibles à l'intérieur d'un ensemble est défini par une adresse de post sélection AP.

L'adresse de colonne sélectionne toutes les colonnes de même rang de tous les groupes. Elle effectue cette sélection grâce à un multiplexeur placé en sortie des colonnes. L'adresse de post sélection sélectionne tous les groupes de même rang dans tous les ensembles simultanément. Cette post sélection est effectuée par activation de tous les amplificateurs de même rang (1 parmi k) des différents ensembles. L'activation d'un amplificateur connecte les colonnes du groupe correspondant à cet amplificateur (et plus exactement la colonne sélectionnée dans ce groupe par l'adresse AC) au plot de l'ensemble dans lequel se situe le groupe, plot auquel est raccordé l'amplificateur.

Les colonnes de redondance peuvent être sélectionnées grâce à un circuit de redondance qui comprend essentiellement un comparateur COMP capable de comparer l'adresse de colonne AC reçue par la mémoire avec des adresses de colonnes défectueuses mémorisées dans un registre de stockage RS. Lorsqu'une adresse défectueuse est appliquée à la mémoire, elle est reconnue par le comparateur dont la fonction est alors d'inhiber le décodeur de colonne DC et de sélectionner une colonne de redondance en remplacement de la colonne défectueuse.

Les groupes de colonnes de redondance sont associés chacun à un amplificateur et sont connectées à cet amplificateur par l'intermédiaire d'un multiplexeur de la même manière que les colonnes de cellules de mémoire du réseau principal sont connectées aux amplificateurs par l'intermédiaire d'un multiplexeur. Mais alors que la liaison des colonnes du réseau principal est contrôlée par le décodeur DC, la liaison des colonnes redondantes est contrôlée par un circuit de sélection de colonnes redondantes CSR couplé à la sortie du comparateur.

Le registre de stockage comprend k groupes de r zones de mémoire, chaque zone étant apte à mémoriser une adresse de colonne définissant une colonne (parmi p) défectueuse. Le groupe dans lequel se situe cette colonne n'est pas identifié ni mémorisé dans la zone de mémoire du registre de stockage. Cependant, si on définit pour chaque groupe de r zones un rang 1 parmi k comme on a défini un rang 1 parmi k pour les groupes de colonnes du réseau et pour les amplificateurs, chaque groupe de r zones de mémoire de rang déterminé est destiné à stocker exclusivement une adresse de colonne défectueuse située dans un groupe de colonnes de ce même rang.

Ainsi, le registre comprend dans l'exemple représenté deux groupes (k=2) de zones de mémoire, parce qu'il y a deux amplificateurs par plot. Le premier groupe comprend deux zones (r=2) désignées par M1a et M2a destinées à stocker des adresses de colonne défectueuses uniquement si ces colonnes se situent dans les groupes de premier rang G0a, G1a, G2a, G3a. Deux adresses défectueuses peuvent être stockées pour deux réparations. Le deuxième groupe comprend deux autres zones M1b et M2b pour stocker des adresses défectueuses de colonnes situées dans les groupes de deuxième rang G0b à G3b uniquement.

Le registre est commandé par l'adresse de post sélection AP, qui définit justement le rang 1 parmi k des groupes et amplificateurs, et qui va servir selon l'invention à définir aussi le rang 1 parmi k du groupe de mémoires de stockage du registre RS. Sous la commande d'un bus PS transmettant l'adresse de post sélection AP, le registre RS ne fournit au comparateur COMP que les contenus des zones de mémoire du groupe dont le rang correspond à cette adresse. Dans ce groupe il y a r zones de mémoires, c'est-à-dire r possibilités de stockage d'adresses de colonnes défectueuses. Si l'une correspond justement à l'adresse AP reçue à l'entrée de la mémoire, le comparateur le signale et indique au circuit de sélection CSR quelle est la mémoire à partir de laquelle la détection a été faite.

Le circuit de sélection CSR est capable alors, sous la commande du comparateur, de définir une colonne de redondance parmi r, simultanément pour tous les groupes de r colonnes de tous les ensembles il ne fait pas la différence entre un groupe et un autre ou un ensemble et un autre, ce qui permet de réduire au minimum la taille du multiplexeur qu'il commande (même taille qu'à la figure 2). Bien entendu, on aura compris que la colonne de redondance désignée (parmi r) est celle qui correspond à la mémoire (parmi r) qui contenait l'adresse défectueuse reconnue par le comparateur.

Lors de la détection d'une adresse défectueuse, une colonne parmi r colonnes de redondance est donc sélectionnée dans chacun des groupes quel que soit leur rang parmi k, et elle est connectée à l'entrée de l'amplificateur correspondant à ce groupe. Mais seul les amplificateurs activés transmettront effectivement l'information vers un plot. Et ne sont activés que les amplificateurs d'un rang déterminé parmi k, en fonction de l'adresse de post sélection AP. Or on n'a autorisé la détection d'adresses défectueuses que pour les colonnes correspondant au même rang parmi k. Il en résulte que même si le circuit de sélection CSR ne fait pas la différence entre les rangs des groupes, l'ensemble du système fait cette différence et établit indirectement une corrélation entre le rang parmi k du groupe qui comporte une colonne défectueuse et le rang parmi k de la colonne de redondance qui va servir à remplacer la colonne défectueuse.

On a ainsi réalisé le but de l'invention qui est d'augmenter les possibilités de redondance sans augmenter l'encombrement à proximité immédiate des colonnes de la mémoire; en particulier on minimise la taille du multiplexeur qui, sous la commande du circuit CSR, désigne une colonne parmi r, et on a rejeté vers la périphérie les éléments supplémentaires rajoutés, tels que les zones de mémoire supplémentaires du registre.

On notera que ces zones de mémoire peuvent être constituées par des batteries de fusibles, ou par des cellules de mémoire électriquement programmables telles que des cellules EPROM ou EEPROM.

**Revendications**

1. Circuit de redondance pour une mémoire comportant k amplificateurs de lecture (A0a, A0b; ...; A3a, A3b) par plot desortie de données (P0,P1,P2,P3), k supérieur à 1, un moyen de sélection (PS) d'un amplificateur de rang donné parmi k pour sélectionner simultanément tous les amplificateurs de même rang raccordés aux différents plots, un registre (RS) de stockage d'adresses de colonnes défectueuses, et un moyen de comparaison (COMP) d'une adresse de colonne reçue par la mémoire avec des adresses contenues dans le registre (RS) de stockage, circuit caractérisé en ce que le registre (RS) de stockage comprend k groupes de zones de mémoire, chaque groupe (M1a, M2a; M1b, M2b) étant repéré par un rang parmi k et étant apte à stocker des adresses de colonnes défectueuses correspondant exclusivement à des colonnes défectueuses raccordées à un amplificateur de même rang que le groupe de zones considéré, et en ce que le moyen de sélection (PS) est apte, lorsqu'il sélectionne les amplificateurs d'un rang donné, à n'autoriser la transmission au moyen de comparaison (COMP) que des adresses défectueuses stockées dans les zones du groupe du rang considéré.

2. Circuit de redondance selon la revendication 1 pour une mémoire comportant :

– un réseau d'éléments de mémoire organisés en n rangées et z ensembles de k groupes de p colonnes, avec n, z, k et p différents de l'unité, chaque ensemble (E0 à E3) correspondant à un plot de données respectif (P0 à P3) parmi z, et chaque groupe (G0a, G0B à G3a, G3b) correspondant à un amplificateur de lecture respectif (A0a, A0b à A3a, A3b) parmi k amplificateurs connectés à ce plot, de telle manière qu'une donnée d'une colonne d'un groupe déterminé dans un ensemble déterminé soit appliquée au plot correspondant à cet ensemble par l'amplificateur correspondant à ce groupe,

– un décodeur de colonne (DC) pour sélectionner une colonne parmi p simultanément dans tous les groupes de tous les ensembles, et un moyen de post-sélection (PS) pour sélectionner un amplificateur parmi k simultanément dans tous les ensembles, en fonction de la réception par la mémoire d'une adresse (AC) de colonne parmi p adresses et d'une adresse (AP) de groupe parmi k, le circuit de redondance étant caractérisé en ce qu'il comporte un circuit d'activation de colonnes redondantes comprenant :

– r colonnes de redondance (CR0a, CR0b à CR3a, CR3b) par groupe dans chacun des ensembles, pour remplacer au moins une colonne défectueuse dans le réseau, r supérieur ou égal à l'unité, les r colonnes de redondance associées à un groupe étant reliées directement à l'amplificateur correspondant à ce groupe,

– un circuit (CSR) de sélection de colonne de redondance pour sélectionner une colonne de redondance parmi r simultanément dans tous les groupes de tous les ensembles, c'est-à-dire pour sélectionner simultanément z.k colonnes de redondance de même rang appartenant toutes à des groupes et des ensembles différents,

– k groupes de mémoires de stockage d'adresses de colonnes défectueuses (M1a, M2b; M1b, M2b), chaque groupe comportant en mémoire r adresses et chaque adresse permettant de désigner une colonne parmi p, chaque groupe de mémoires étant dédié au stockage d'adresses de colonnes défectueuses correspondant à un seul rang de groupe de colonnes parmi k, sans distinction entre les ensembles auxquels peuvent appartenir les colonnes défectueuses,

– un moyen de sélection (PS) de groupe de mémoires, apte à sélectionner un groupe de mémoires parmi k lors de la réception par la mémoire d'une adresse de groupe (AP) parmi k,

– un moyen (COMP) pour comparer une adresse de colonne parmi p, reçue par la mémoire, à toutes les adresses d'un groupe de mémoires sélectionné, et pour d'une part inhiber le décodeur de colonnes (mais non le moyen de post sélection) et d'autre part commander la sélection par le circuit de sélection de colonne de redondance (CSR) d'une colonne de redondance déterminée en fonction du résultat de la comparaison.

## Patentansprüche

1. Redundanzkreis für einen Speicher, umfassend k Leseverstärker (A0a, A0b; ...; A3a, A3b) pro Datenausgangsanschluß (P0, P1, P2, P3), wobei k größer als 1, ein Auswahlmittel (PS) eines Verstärkers mit gegebenem Rang aus k zum gleichzeitigen Auswählen sämtlicher Verstärker desselben Rangs, die mit verschiedenen Anschlüssen verbunden sind, ein Register (RS) zum Speichern von Adressen von fehlerhaften Spalten, und ein Vergleichsmittel (COMP) einer von dem Speicher empfangenen Spaltenadresse mit im Speicherregister (RS) enthaltenen Adressen, der Kreis dadurch **gekennzeichnet**, daß das Speicherregister (RS) k Gruppen von Speicherzonen aufweist, wobei jede Gruppe (M1a, M2a; M1b, M2b) durch einen Rang aus k gekennzeichnet ist und zum Speichern der Adressen von fehlerhaften Spalten entsprechend ausschließlich fehlerhaften Spalten geeignet ist, die mit einem Verstärker desselben Rangs wie die betrachtete Gruppe von Zonen verbunden sind, und daß das Auswahlmittel (PS), wenn es die Verstärker mit gegebenem Rang auswählt, geeignet ist, nur die Übertragung zum Vergleichsmittel (COMP) der in den Zonen der Gruppe des betrachteten Rangs gespeicherten fehlerhaften Adressen zu gestatten.

2. Redundanzkreis nach Anspruch 1 für einen Speicher umfassend:

– ein Netzwerk von Speicherelementen, die in n Reihen und z Sätzen von k Gruppen von p Spalten organisiert sind, wobei n, z, k und p von Eins verschieden, wobei jeder Satz (E0 bis E3) einem entsprechenden Datenanschluß (P0 bis P3) aus z entspricht und wobei jede Gruppe (G0a, G0b bis G3a, G3b) einem entsprechenden Leseverstärker (A0a, A0b bis A3a, A3b) aus k mit diesem Anschluß verbundenen Verstärkern entspricht derart, daß ein Datensignal einer Spalte einer bestimmten Gruppe in einem bestimmten Satz durch den dieser Gruppe entsprechenden Verstärker an den entsprechenden Anschluß dieses Satzes gelegt wird,

– einen Spaltendekodierer (DC), um eine Spalte aus p gleichzeitig in sämtlichen Gruppen sämtlicher Sätze auszuwählen, und ein Nach-Auswahlmittel (PS), um einen Verstärker aus k gleichzeitig in sämtlichen Sätzen auszuwählen, abhängig vom Empfang einer Spaltenadresse (AC) aus p Adressen und einer Gruppenadresse (AP) aus k durch den Speicher, wobei der Redundanzkreis dadurch gekennzeichnet ist, daß er einen Kreis zur Aktivierung von redundanten Spalten umfaßt, aufweisend:

– r Redundanzspalten (CR0a, CR0b bis CR3a, CR3b) pro Gruppe in jedem der Sätze zum Ersetzen wenigstens einer fehlerhaften Spalte im Netzwerk, wobei r größer oder gleich Eins, wobei die einer Gruppe zugeordneten r Redundanzspalten direkt mit dem dieser Gruppe entsprechenden Verstärker verbunden sind,

– einen Kreis (CSR) zur Redundanzspaltenauswahl, um eine Redundanzspalte aus r gleichzeitig in sämtlichen Gruppen sämtlicher Sätze auszuwählen, d.h. um gleichzeitig z.k Redundanzspalten vom selben Rang auszuwählen, die sämtlich zu verschiedenen Gruppen und Sätzen gehören,

– k Gruppen von Speichern zur Adressenspeicherung von fehlerhaften Spalten (M1a, M2a; M1b, M2b), wobei jede Gruppe im Speicher r Adressen umfaßt und wobei jede Adresse die Bezeichnung einer Spalte aus p gestattet, wobei jede Gruppe von Speichern der Adressenspeicherung von fehlerhaften Spalten entsprechend einem einzigen Gruppenrang von Spalten aus k zugeeignet ist, ohne Unterscheidung unter den Sätzen, zu denen die fehlerhaften Spalten gehören können,

– ein Gruppenauswahlmittel (PS) von Speichern, das geeignet ist, eine Gruppe von Speichern aus k bei Empfang einer Gruppenadresse (AP) aus k durch die Speicher auszuwählen,

– ein Mittel (COMP), um eine durch den Speicher empfangene Spaltenadresse aus p mit sämtlichen Adressen einer ausgewählten Gruppe von Speichern zu vergleichen und um einerseits den Spaltendekodierer (aber nicht das Nach-Auswahlmittel) zu hemmen und andererseits die Auswahl einer bestimmten Redundanzspalte abhängig vom Ergebnis des Vergleiches durch den Kreis zur Redundanzspaltenauswahl (CSR) zu steuern.

## Claims

1. A redundancy circuit for a memory comprising k reading amplifiers (A0a, A0b; ...; A3a, A3b) by data output terminals (P0, P1, P2, P3), k being greater than 1, means (PS) for selecting an amplifier having a given order number among k, in order to selectsimultaneously all the amplifiers having the same order number connected to the different terminals, a register (RS) for storing addresses of defective columns, and means for comparison (COMP) of a column address received by the memory with addresses contained in the storage register (RS), this circuit being characterized in that the storage register (RS) comprises k groups of memory zones, each group (M1a, M2a; M1b, M2b) being referenced by one order number among k and being adapted to store defective column addresses corresponding exclusively to defective columns connected to an amplifier of the same order number as the group of zones considered , and in that the selection means (PS) is adapted to authorise, when it has selected the amplifiers having a given order number, only the transmission to the means for comparison (COMP) only of defective addresses stored in the zones having the group order number considered.

2. A redundancy circuit as claimed in claim 1 for a memory comprising:

– a network of memory elements organised in n lines and z sets of k groups of p columns, n, z, k and p all differing from unity, each set (E0 to E3) corresponding to a respective data terminal (PD to P3) among z, and each group (G0a, G0b to G3a, G3b) corresponding to a respective reading amplifier (A0a, A0b to A3a, A3b) among k amplifiers connected to this terminal, in such a manner that a data item of a column of a given group in a given set is applied to the terminal corresponding to this set by the amplifier corresponding to this group,

– a column decoder (DC) for selecting one column among p simultaneously in all the groups of all the sets, and a post-selection means (PS) for selecting one amplifier among k simultaneously in all the sets, depending on the reception by the memory of one column address (AC) among p addresses and one group address (AP) among k, the redundancy circuit being characterized in that it comprises a circuit for activation of redundant columns comprising:

– r redundancy columns (CR0a, CR0b to CR3a, CR3b) per group in each of the sets, for replacing at least one defective column in the network, r being greater than or equal to one, the r redundancy columns associated with a group being directly connected to the amplifier corresponding to this group,

– a redundancy column selection circuit (CSR) for selecting one redundancy column among r simultaneously in all the groups of all the sets, that is to say for selecting simultaneously z.k redundancy columns of the same order number all belonging to different groups and sets,

– k groups of memories for storing addresses of defective columns (M1a, M2a; M1b, M2b), each group comprising in the memory r addresses and each address making it possible to designate one column among p, each group of memories being assigned to the storing of defective column addresses corresponding to a single group of columns having the same order number among k, without distinction between the sets to which the defective columns may belong,

– a memory group selection means (PS) adapted to select one group of memories among k after the reception by the memory of one group address (AP) among k,

– a means (COMP) for comparing one column address among p, received by the memory, with all the addresses of a group of memories selected, and on the one hand to inhibit the column decoder (but not the post-selection means) and, on the other hand, to order the selection by the redundancy column selection circuit (CSR) of a particular redundancy column depending on the result of this comparison.

FIG_1

FIG_2

Z×k groupes G
z×k×p colonnes

E0 E1 E2 E3

G0a (p col) CR0a r CR0b r G0b (p col) G1a (pcol) CR1a r CR1b r G1b (p col) G2a G2b CR2a CR2b G3a G3b CR3a CR3b

AC DC

CSR 1/r

COMP (AC) M1 (p bits) M2 (p) RS

AC

AP

A0a A0b A1a A1b A2a A2b A3a A3b

P0 P1 P2 P3

EP 0 433 141 B1

FIG_3

FIG_4

EP 0 433 141 B1